# EUROPEAN PATENT SPECIFICATION

(11) **EP 0 602 271 B1**
(45) Date of publication and mention of the grant of the patent: **28.04.2004**
(21) Application number: 92121508.3
(22) Date of filing: 17.12.1992
(51) Int. Cl.: H01L 21/66

(54) **Testing and repairing process for memory chips on a wafer, each chip having a redundancy circuit**
Verfahren zum Testen und Reparieren von Speicherchips auf einem Wafer, wobei jeder Chip einen Redundanzschaltkreis aufweist
Procédé de test et de réparation pour puces memoire sur une tranche, chaque puce ayant un circuit de redondance

(43) Date of publication of application: 22.06.1994
(73) Proprietor: SAMSUNG ELECTRONICS CO. LTD., Suwon, Kyungki-do (KR)
(72) Inventor: Moon, Hong-bae, Jeonju-city, Jeonlabuk-do (KR); Ku, Bon-youl, Daeku (KR); Song, Gi-seung, Yongin-gun, Kyungki-do (KR); Seo, Tae-wook, Yongin-gun, Kyungki-do (KR)
(74) Representative: TER MEER STEINMEISTER & PARTNER GbR

(56) References cited:
- PATENT ABSTRACTS OF JAPAN vol. 9, no. 123 (E-317)28 May 1985
- PATENT ABSTRACTS OF JAPAN vol. 6, no. 103 (E-112)12 June 1982
- INSPEC, Access.Nr.: 2 160 517; New Electronics, 6 Sept. 1983, UK, Vol.16, Nr. 17, pp.19-21, T. WEARDEN:"Avoiding VLSI Memory Defects"
- Proceedings of the SPIE - The International Society for Optical Engineering, 1989, USA, vol. 1087, pages 507-512
- Siemens Forschungs- und Entwicklungsberichte, 1984, West Germany, vol. 13, No. 4, pages 196-200

## Description

### Background of the Invention

The present invention relates to a testing and repairing process for memory chips on a wafer for higher productivity by simplifying the quality testing and repairing processes of a memory device such as a DRAM, SRAM, etc., which has a redundancy circuit. Recently, as high integration of a memory device makes it possible to shorten the distance between lines, defects tend to increase throughout the manufacturing process, which drops yield seriously. Therefore, semiconductor manufacturers have adopted a redundancy technique for achieving a higher productivity by restraining the yield drop which may result from processing deficiencies in which technique a reserve circuit block is located in a chip so as to repair the repairable chips resulted from a mere process poorness and a regular circuit containing minor defect due to small process poorness is to be replaced with a reserve circuit after test of the chip in the wafer.

For example, in a semi-conductor memory circuit, quality enhancement is achieved by integrating into chips reserve blocks of reserve rows and columns, and replacing the row or column of a block containing a poor bit of a regular cell array with a reserve row/column block. This redundancy technique is very effective in DRAMs and SRAMs in which cells of identical function are arranged. To replace a poor row or column having a poor bit of memory device having a poor bit with a fully functional row or column, a program device and method for de-activating the poor row/column and activating the reserve one is required. The most well-known program element and program method for redundancy are the fuse composed of polysilicon resistors and the like, and an electrical fuse method for electrically blowing the fuse. Link of polysilicon, polycide, etc., or a laser-beam method for cutting-off this link by applying laser-beam are another program element and program method for redundancy.

In the electrical fuse method, transistor for high current driving, control circuits and special pad for supplying current, etc., for cutting off the fuse, should be integrated onto the chips, which has demerits of occupying too much chip area, and delaying program access time. However, certain advantages are attained in that testing and repairing equipment are inexpensive and high reliability can be achieved by protecting the fuse portion with a protective film.

In the laser-beam method, the initial cost is very high because of the expensive testing and repairing equipment, and high throughput is required to have the stability of laser beam and to decide the exact position of laser beam. However, this method has advantages in that the redundancy circuit design is easy and chip area can be used economically because a plurality of links can be arranged in a very small area in the chip. Accordingly, due to the trend of ultra-minimization and high-integration of semiconductor memory device in recent years, the laser beam method is becoming more prevalent.

The wafer testing process of the laser beam method comprises a pre-laser testing step, a laser repairing step, and a final quality classifying step. Here, to shorten the test time while maintaining device's characteristics and quality, a method has been adopted by which a circuit with enough margin for designing and processing is to be searched and the test item with no defect is to be skipped. However, poorness about the skipped items which can be caused by process variables shifting frequently, inevitably brings about yield drop in the subsequent package testing process.

Referring to FIG.1 through FIG.5, in the conventional wafer testing process, after finishing element formation on the wafer, photoresist pattern 24 is formed by an ordinary photography etching process (as shown in FIG.2) on a wafer, on which a passivation film 22 of about 6,000Å thickness is then deposited. Photoresist pattern 24 is used as a mask for removing passivation film 22, that is, PSG film, on pad 20 and above link 14. Here, reference numeral 10 denotes substrate wafer, 12 is an oxide film, 16 is an HTO film, and 18 is a PSG film. As shown in FIG.3, by using photoresist pattern 24, PSG film is selectively removed and pad 20 is opened, and PSG film on link 14 is removed to reduce cutting miss due to the thickness of protecting films on the link in the laser repairing process (step 101).

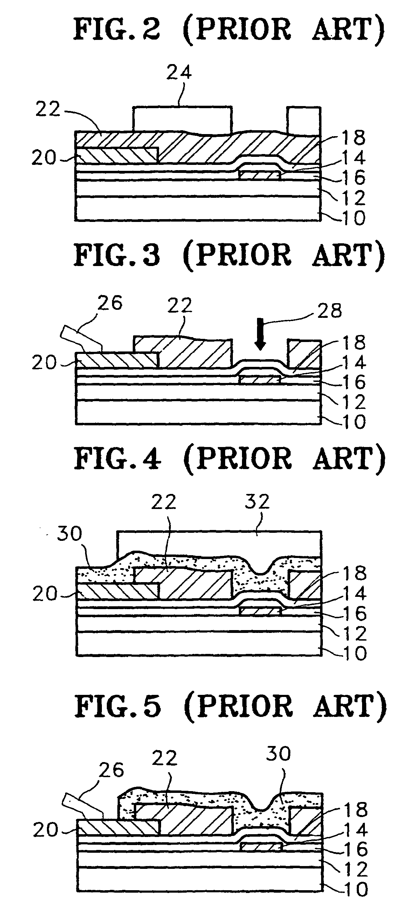

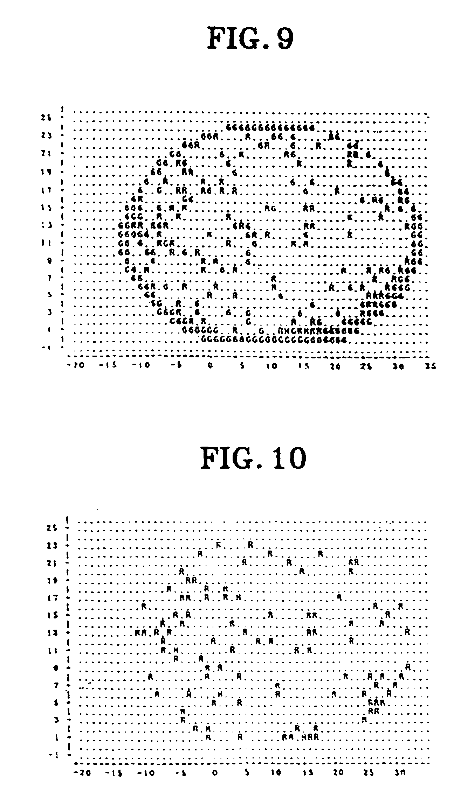

After finishing photography etching, a wafer is loaded on probe equipment (e.g., EG2001X), whereby a probe contacts the open pad, and then a pre-laser test is executed by test equipment (e.g., Q2/52). According to the pre-laser test results, a wafer map is made for showing whether the chips on a wafer are good or bad (step 102). After the pre-laser test, the wafer is loaded on laser equipment (e.g., 9000D) for laser repairing, and this laser equipment searches repairable chips (each marked with an "R" in FIG.9) according to the transferred pre-laser test result, and inspects and cuts-off the designated link with a laser beam. Therefore quality enhancement is accomplished by de-actvating a poor row or column, activating a normal reserve row or column, and replacing the former with the latter (step 103). A wafer which has been thus laser-repaired is loaded once again on the deposition equipment, and nitride film 30 of about 6,000Å is deposited over the entire surface. This nitride film is for protecting the cut-off link portion from contamination which can be caused by physical impact, humidity, temperature or other factors in the fabrication process. Next, photoresist pattern 32 for opening pad 20 is formed on nitride film 30 by an ordinary photoresist process, and the formed photoresist pattern 32 is used as an etching mask and by removing the nitride film 30 on the pad 20 as shown in FIG.4. Here, pad 20 is to be opened as shown in FIG.5 in order to provide the linked section in which metal lines are connected during assembly of the device.

Henceforth, the wafer is brought to the final quality testing step (step 105) through a back-lap process for physically grinding the back side of the wafer by about 100µm. In the final quality testing step, every chip on a wafer is scanned and tested automatically in order to choose only poor chips on a wafer, and to package the good chips. Then, an inking dot of 2mm diameter for marking the bad ones is placed on each poor die by an on-line inking method.

The conventional wafer testing process has certain problems in that contamination due to dust and such like occurs frequently so that quality and reliability diminish unless clean-room conditions are properly maintained, because the test is to be executed through the repetition of 2-step process of fabrication-testing-fabrication-testing.

Additionally, throughput time cannot be shortened because the conventional wafer test process goes through the 2-step process. Further, since a sample test is executed after repairing process according to the pre-laser test results, to skip the inking process if goodness die ratio is more than 95%, and to ink poorness chip with the wafer map of pre-laser result without doing testing whether the repaired chips have been repaired as it should if goodness ratio is less than 95%, a yield drop as large as the number of unrepaired chips is resulted and it is difficult to cope with the package yield drop due to redundancy circuit's defect or cutting miss in laser repairing.

A testing and repairing process for LSI and VLSI memory chips on a wafer is known from "New Electronics". September 6, 1983, UK, vol. 16, no. 17, pages 19 to 21. During this testing and repairing process a complete memory chip is first automatically scanned and checked. In particular, a real time bit mapping step for pre-laser testing is performed first and than, during a laser repairing step. defective bits are replaced by reserve bits of redundancy circuits provided on the memory chip. For laser repairing information obtained by 100 % bit-by-bit checking during real time bit mapping is used. The laser repairing is performed by vaporization of respective polysilicon links in a memory chip to be repaired by means of a fine laser beam. Thereafter, the device, i.e. the tested and repaired memory chip, is retested.

The article of H.Hackl "Matematisch-statistisches Verfahren zur Optimierung von Vorchargen-Stichproben bei Halbleitersystemen", Siemens Forschungs-und Entwicklungsberichte, 1984, West Germany, vol. 13, no. 14, pages 196 bis 200, is concerned with quality testing in general and sample testing in particular. This documents teaches, that, as an alternative to 100 % testing of all items in a lot, testing can be limited to a sample of the items of the lot to reduce the amount of testing carried out. To decide whether the quality of a lot is sufficient a number of n items is tested and the number of defective items is compared with a critical number c to decide whether a lot have to be rejected or not. Rejection of the lot is followed by one of three options: first, all items of the lots are tested to determine all defective items; second, the lot is returned to the supplier; or third, the entire lot is discarded.

Furthermore, the article of Hackl discloses a testing process for memory chips of a wafer wherein a sample of n chips is selected, and the selected chips are packed and tested. Thereafter, according to the results of this testing it is decided whether all chips of the lot will be mounted and packed or whether the whole lot will be discarded.

The object of the invention is to provide a new testing and repairing process for memory chips on a wafer which simplifies the processing steps and increases the package yield in the wafer.

This object is achieved by the method according to claim 1.

In particular, according to the present invention it is not only possible to skip a final quality classifying step in accordance with the result of a sample test performed after the laser repairing step but also to perform quality marking quickly and reliably so as to speed up the whole manufacturing process.

### Brief Descriptions of the Drawings.

Further features and advantages will become more apparent from the following and more particular description of the preferred embodiment of the invention as illustrated in the accompanying drawings in which the same reference characters generally refer to like parts throughout the view, and in which:

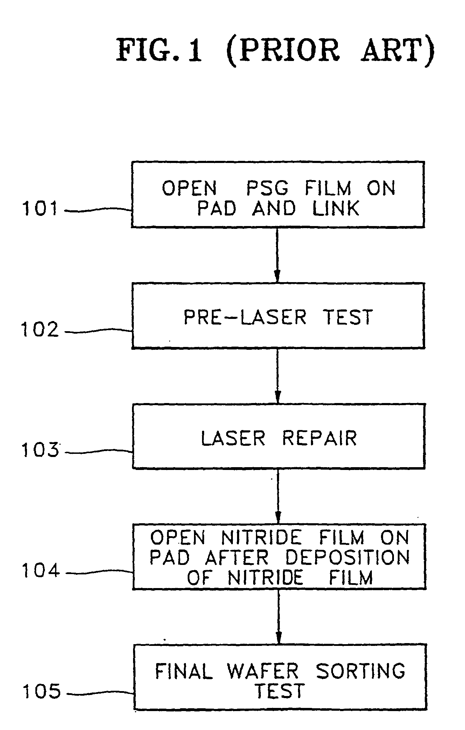

FIG. 1 is a process flowchart of a conventional wafer testing process;
FIG.2 through FIG.5 are sectional view for showing a two-step manufacturing process of the conventional wafer testing process;

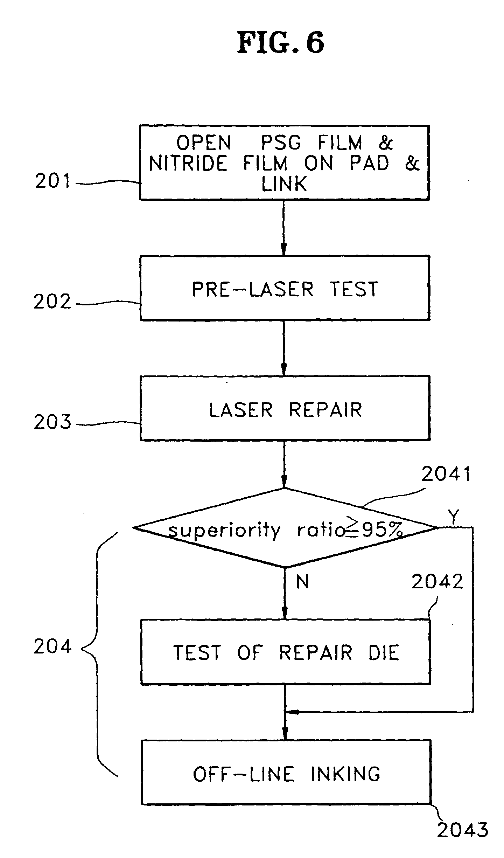

FIG.6 is a flowchart for explaining a wafer testing process according to the present invention;

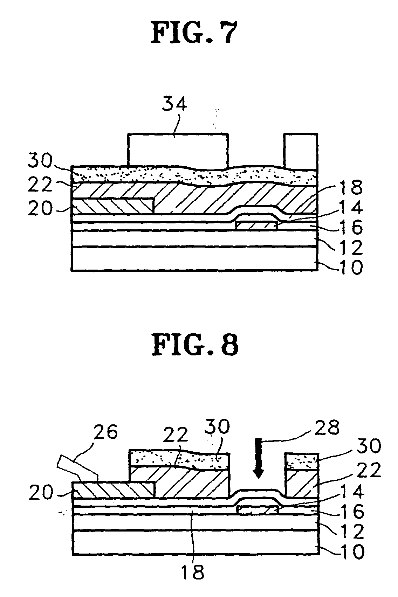

FIGs.7 and 8 are sectional views for explaining a simplified one-step manufacturing process of a wafer testing process according to the present invention;
FIG.9 is a wafer map of the result of a pre-laser test; and
FIG.10 is a wafer map which extracts the position information about the repairable chips according to the present invention.

The present invention will be explained in reference with FIG.6 to FIG.8.

Referring to FIG.6, a wafer testing process according to the present invention comprises the step of opening protection film on a pad and link (step 201), a pre-laser testing step (step 202), a laser repairing step (step 203), and a final quality testing step (step 204). In the step of opening protection film on a pad and link as shown in FIG.7, PSG film 22 and nitride film 30 are sequentially deposited less than approximately 6,000Å of thickness on a wafer on which the device has been formed. Then, the wafer undergoes a back-lap process, and photoresist pattern 34 for removing a protection film on the pad and link is formed on nitride film 30 by an ordinary photography process. Subsequently, as shown in FIG.8, photoresist pattern 34 is used as an etching mask so that nitride film 30 and PSG film 22 may be etched to completely remove the protection film on pad 20. To make the oxide film's thickness less than 8,000Å which is required to do laser-repair on link 14, PSG film 18 is over-etched so that the remaining oxide film's thickness should be less than 5,000Å. As illustrated above, cutting miss ratio can be lowered by over-etching the portion above link 14 and making it thin. That is, according to the present invention, deposition and etching steps are to proceed in the same fabrication step so that the two fabricating steps of the conventional method are reduced to one, so throughput time can be shortened remarkably. Additionally, in a subsequent laser-repairing process, because PSG film and nitride film exist on the alignment mark part, it was worried that allignment mark discrimination would be difficult, and thus the part to cut would not be cut exactly. However, a reticle is changed and alignment mark part is opened during the etching process, improving the quality of the product.

The pre-laser testing step (step 202) is to optimize the testing conditions for increasing the accumulated yield. Considering the characteristics of memory devices such as DRAM or SRAMs in general, as temperature increases, the mobility of electrons and their drift velocity decrease and yield voltage is lowered so that the characteristic becomes more sensitive to the influence of noise. Normally, the comsumed current increases in the stand-by condition and decreases in the dynamic condition. The refresh characteristic, one of the most important characteristics of a DRAM, decreases sharply as the temperature increases, and under higher temperatures, becomes poor in comparison with normal temperature characteristics. In the wafer testing process so far, final wafer classification testing proceeds in a normal temperature and emphasizes on filtering DC parameter deficiency and AC parameter deficiency, a yield drop in package testing must be willingly accepted for the part showing poor device characteristic according to the temperature increase.

However, because the problem in the fabrication process as well as process stabilization are checked in the package instead of in the wafer itself, assembly cost is increased, and a feedback time for coping with the problems originated in the fabrication is lengthened as much as the time required for assembly and package testing. Thus, a severer test is necessary at wafer level.

Accordingly, along with the process simplification, optimization of many factors in the pre-laser test is effected so as to enhance accumulated yield itself as well as package yield. In this connection, conditions not to sacrifice good chips are searched by considering the effect of noise in the wafer level so as to increase the accumulated yield only by way of the pre-laser test. One step of testing temperature condition is determined by finding the poor temperature point for each parameter according to the temperature of the device to be tested, and the weakest test item which has a lot of fault factors in package test is applied to the repairing test so that repairable chips can replace faulty rows or columns with a redundancy.

The laser repairing step (step 203) is the same as the conventional method described above, so a detailed explanation thereof is omitted.

The final quality testing step (step 204) comprises a step (step 2041) of judging if the goodness rate is not less than 95% by performing sample test after finishing laser-repairing, a step (step 2042) of selecting and testing only repairable chips if below 95 %, and a step (step 2043) of off-line inking performed after step of 2041 or 2042.

Relating to step 2042, only repairable dies (marked "R") are extracted from the wafer map of pre-laser test result as shown in FIG.9, the extracted information as shown in FIG.10 is temporarily stored in the memory of test equipment (Q2/25), and this stored information is loaded on the probe equipment EG2001X, after which, with the X-Y coordinates of repairable dies according to the information, only repairable dies are to be tested by the test equipment and probe equipment. To choose only poor chips from a wafer and to package only the good chips by an off-line inking process, poorness indication markings for identifying the quality in the assembly die attach process is to be inked on poor chips.

These poorness indication markings are a dot mark of a diameter not less than 20 mil. The off-line inking method, which is different from the on-line inking method for inking while proceeding with real time testing, executes a test first, and carries out inking for only poor chips by using a PC/AT computer system with the Binning result which is a reference to decide quality according to the X-Y position of a tested wafer and other test results. Hence, the off-line inking method provides faster inking velocity, more uniform inking dot size, and easier control than the on-line inking method, so that down-time decrease due to inking equipment defects is reduced, thereby enhancing productivity and facilitating the automation of the fabrication process.

As described above, the present invention is to simplify and optimize a wafer test process. Explanations about the advantages due to this invention in comparison with the conventional method are as follows.
1. As shown in Table 1, from the device developing step, a reticle for process simplification is manufactured. The manufacturing process period and wafer testing process period can be shortened by more than 48 hours in comparison with the conventional method, so that the productivity of the test process can be enhanced by more than 50% in mass-production.

**< Table 1 >**

| | process Sequence | Conventional method | Present method | Changes |
|---|---|---|---|---|
| 1 | PSG deposit | 6000 ± 500Å | 6000 ±500Å | Same |
| 2 | Photography process | Perform | Omit | Changed |
| 3 | Bake before etching | Perform (130 °C 10min) | Omit | Changed |
| 4 | Etching process | Perform | Omit | Changed |
| 5 | Photosensing film dry process removal | Perform | Omit | Changed |
| 6 | Photosensing film wet process removal | Perform | Omit | Changed |
| 7 | Laser Test | Perform | Omit | Changed |
| 8 | Cleaning after laser-test | Perform | Omit | Changed |
| 9 | Nitride film deposit | 6000 ± 500 Å | 6000 ± 500Å | Same |
| 10 | Photography process | Perform photosensing film thickness (17500 Å) | Perform photosensing thickness (21500 Å) | Same (Reticle changed) |
| 11 | Etching process | nitride film etching | nitride film + oxide film etching | Changed |
| 12 | Rear surface coating | Perform photosensing film thickness (30000 Å) | Perform photosensing film thickness (30000 Å) | Same |
| 13 | Etching process | Perform 425 ±25µm | Perform 425 ±25µm | Same |

2. As shown in Table 2, according to the present invention, because a passivation film is removed above the link after laser-repairing, lower reliability which can be generated from high-temperature, high humidity or temperature shock becomes a serious concern. However, improved results have been obtained from a result of reliability test. 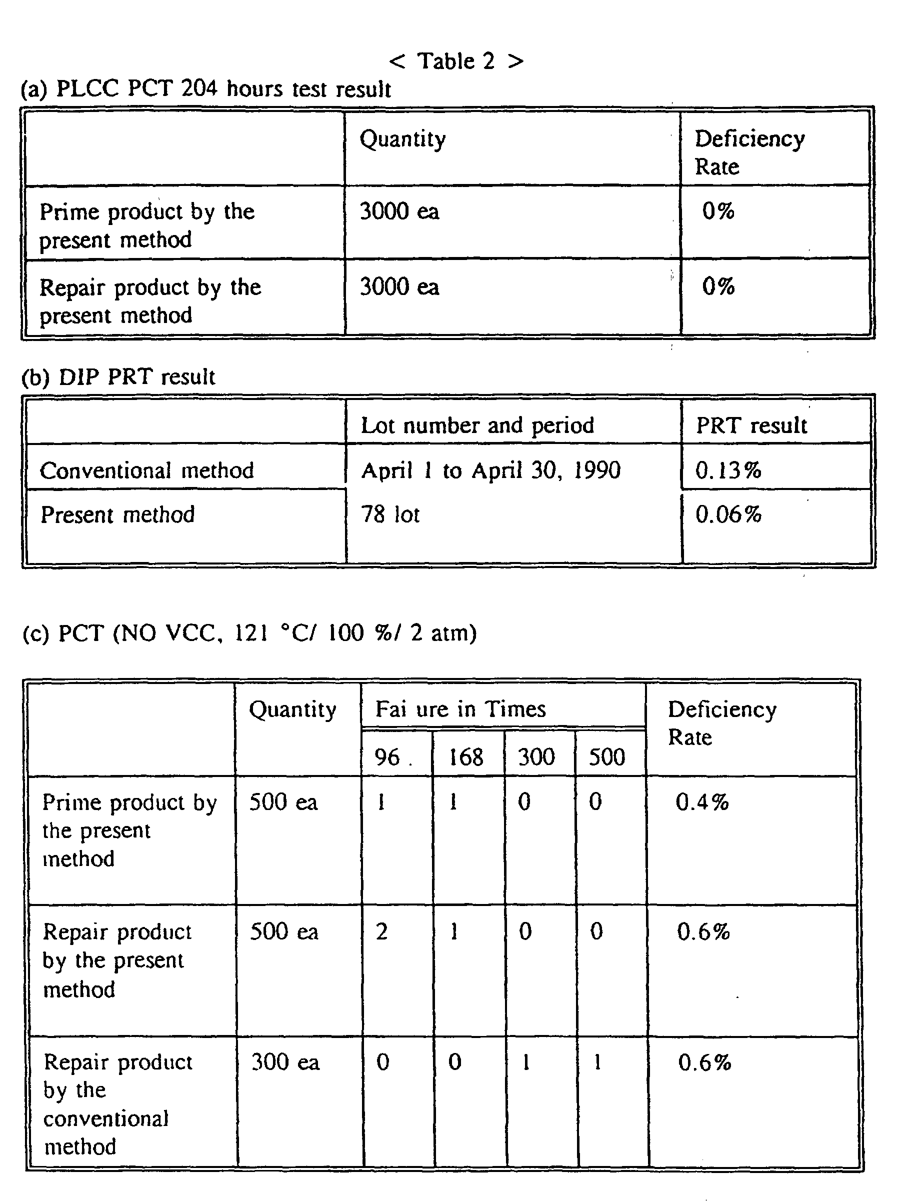
3. As shown in Tables 3 and 4, the accumulated yield increases by about 4.6% due to the optimization of the pre-laser test.

**Table 3**

| | P/L | EDS | P/B | H/S | CUM Yield | PRT |
|---|---|---|---|---|---|---|
| Conventional condition | 94.5 % | 97.3 % | 97.3 % | 96.5 % | 83.9 % | 0.1 % |
| Optimized condition of the present invention | 93.9 % | - | 97.3 % | 96.9 % | 88.5 % | 0.0 % |

**< Table 4 >**

| Item | | Pre-laser | | Changes | EDS Conventional condition | BIN2 test (FAR ≤ 95%) Optimized condition | Changes |
|---|---|---|---|---|---|---|---|
| | | conventional condition | Optimized condition | | | | |
| Open | | Y | Y | - | Y | Y | - |
| Short | | Y | Y | - | Y | Y | - |
| ST BY | TTL | Y | Y | - | Y | Y | - |
| | CMO S | N | Y | limit= 750µA | Y | Y | Limit= 750µA |
| In Leakage | | N | Y | limit= 10µA | N | Y | Limit= 10µA |
| Out Leakage | | N | Y | limit= 10M | N | Y | Limit= 10µA |
| Repair Test | | Y Vcc=4 V Ref=20ms Pattern = March | Y Vcc=4/6V Ref=20 ms Pattern= made for checking March and Adcomp at the same time | High Margin Vcc= 6V Adcomp Pattern Added | Y Vcc=4/5/6V Ref=4ms Pattern = Adcomp+ Static Ref | Y Vcc= 4/6V Ref= 20ms Pattern= made for checking March and Adcomp at the same time | Vcc=5V poorness is skipped, Refresh condition is poor. |
| TEMPERA TURE | | 85 °C | 83 °C | Same as in H/S | Room | 83°C | Same as in H/S |

4. As shown in Table 5, by adopting the off-line inking method, rework of the laser and pre-laser test is possible, and inking miss ratio due to inking equipment defects is reduced while avoiding quality deterioration due to inking.

**< Table 5 >**

| | Conventional On-line Inking | Present invention's Off-line Inking |
|---|---|---|
| Advantages | Additional equipments for inking is unnecessary because inking is being done while testing | 1. Faster inking speed (3 -4 /sec) 2. Easy control of dot size 3. Delay time due to inker poorness is decreased. 4. Essential for automation 5. Essential for process simplification 6. One inker equipment is enough for a pararrel test more than two item tests 7. Productivity increase due to work reduction. 8. Removal of yield decrease due to poor testing |
| Disadvantages | 1. Setting more than 2 inkers is difficult when testing more than 2 items 2. In case of poor test due to inker poorness and other causes, it becomes the causes for inker removal and reliability deficiency. 3. Inking is impossible when introducing the process simplification. | 1. Data processing must be executed carefully because laser repairing, BIN2 test, off-line inking are to be accomplished by the pre-laser test result. 2. An additional process is added. |

5. Probing quality of a pad can be improved and the number of probe particles as well as the number of wafer particles can be brought to zero by one testing step.

## Claims

1. A testing and repairing process for memory chips on a wafer, each chip having redundancy circuits including links and pads for electrical connection both covered by a passivation film,
said process comprising the steps of:
(a) selectively removing, by photography etching process, a passivation film portion disposed over said pads and over said links;
(b) performing a pre-laser test by electrically testing every chip on a wafer through said exposed pads to determine repairable chips on said wafer;
(c) repairing said repairable chips by cutting said links on said repairable chips with a laser beam according to the repairing information obtained by said pre-laser test;
(d) testing a sample of repaired chips after said laser repairing step to determine a representative goodness ratio per wafer;
(e) quality testing all of said repaired repairable chips to determine which of said repaired repairable chips were unsuccessfully repaired, if said goodness ratio is less than a predetermined value, and omitting said quality testing step if said goodness ratio is greater than or equal to said predetermined value, and
(f) quality marking each of said defective unrepairable chips and each of said unsuccessfully repaired repairable chips determined by said quality testing step.

2. A wafer testing process as claimed in claim 1, **characterized, in that** said passivation film is composed of any one selected from the group consisting of a PSG film, a nitride film and a combination thereof.

3. A wafer testing process as claimed in claim 1, **characterized, in that** step (a) is carried out by sufficiently overetching an intermediate insulation film interposed between said passivation film and said program elements to make the thickness thereof less than 800 nm (8000 Å), for minimizing cut-off failure of program elements by laser beam.

4. A wafer testing process as claimed in claim 1, **characterized, in that** step (a) is carried out by opening an alignment mark portion for laser-repairing while simultaneously performing pad-opening.

## Patentansprüche

1. Test- und Reparaturprozess für Speicherchips auf einem Wafer, wobei jeder Chip über Redundanzschaltkreise mit Verbindungen und Kontaktflecken für elektrische Verbindungen verfügt, die beide durch einen Passivierungsfilm bedeckt sind, mit den folgenden Schritten:
(a) selektives Entfernen, durch einen fotografischen Ätzprozess, eines über den Kontaktflecken und den Verbindungen liegenden Passivierungsfilmabschnitts;
(b) Ausführen eines Vor-Lasertests durch elektrisches Testen jedes Chips auf einem Wafer mittels der freigelegten Kontaktflecke, um reparierbare Chips auf dem Wafer zu bestimmen;
(c) Reparieren der reparierbaren Chips durch Durchtrennen der Verbindungen auf denselben mittels eines Laserstrahls entsprechend der durch den Vor-Lasertest erhaltenen Reparaturinformation;
(d) Testen einer Probe reparierter Chips nach dem Laserreparaturschritt zum Bestimmen eines repräsentativen Anteils guter Chips pro Wafer;
(e) Qualitättesten aller reparierten reparierbaren Chips zum Bestimmen, welche derselben ohne Erfolg repariert wurden, wenn der Anteil guter Chips weniger als ein vorbestimmter Wert ist, und Weglassen des Qualitätstestschritts, wenn der Anteil guter Chips größer als der vorbestimmte Wert oder gleich groß wie dieser ist; und
(f) Qualitätsmarkierung jedes der fehlerhaften unreparierbaren Chips und jedes der ohne Erfolg reparierten reparierbaren Chips, wie sie durch den Qualitätstestschritt ermittelt wurden.

2. Wafertestprozess nach Anspruch 1, **dadurch gekennzeichnet, dass** der Passivierungsfilm aus einem beliebigen besteht, der aus der aus einem PSG-Film, einem Nitridfilm und einer Kombination hiervon bestehenden Gruppe besteht.

3. Wafertestprozess nach Anspruch 1, **dadurch gekennzeichnet, dass** der Schritt (a) dadurch ausgeführt wird, dass ein zwischen den Passivierungsfilm und die Programmierelemente eingefügter Zwischen-Isolierfilm so überätzt wird, dass dessen Dicke zu weniger als 800 nm (8000 Å) wird, um Durchtrenn-Fehlschläge bei den Programmierelementen durch den Laserstrahl zu minimieren.

4. Wafertestprozess nach Anspruch 1, **dadurch gekennzeichnet, dass** der Schritt (a) durch Öffnen eines Ausrichtungsmarkierungsabschnitts für Laserreparatur unter gleichzeitigem Ausführen des Öffnens des Kontaktflecks ausgeführt wird.

## Revendications

1. Procédé de test et de réparation pour puces de mémoire sur une tranche, chaque puce ayant des circuits de redondance comprenant des liaisons et des pastilles pour la connexion électrique, les deux étant recouvertes d'une couche de passivation,
ledit procédé comprenant les étapes consistant à :
a) supprimer de façon sélective par un procédé de photogravure une portion de couche de passivation disposée sur lesdites pastilles et sur lesdites liaisons ;
b) effectuer un test avant traitement au laser en testant de façon électrique chaque puce sur une tranche à travers lesdites pastilles exposées pour déterminer les puces réparables sur ladite tranche ;
c) réparer lesdites puces réparables en coupant lesdites liaisons sur lesdites puces réparables avec un faisceau laser selon les informations de réparation obtenues par ledit test avant traitement au laser ;
d) tester un échantillon de puces réparées après ladite étape de réparation au laser pour déterminer un taux de qualité représentatif par tranche ;
e) tester la qualité de l'ensemble desdites puces réparables réparées pour déterminer celles desdites puces réparables réparées dont la réparation a échoué, si le taux de qualité est inférieur à une valeur prédéterminée, et omettre ladite étape de test de qualité si ledit taux de qualité est supérieur ou égal à ladite valeur prédéterminée, et
f) identifier la qualité de chacune desdites puces irréparables défectueuses et de chacune desdites puces réparables dont la réparation a échoué déterminée par ladite étape de test de qualité.

2. Procédé de test de tranche selon la revendication 1, **caractérisé en ce que** ladite couche de passivation se compose d'une couche quelconque sélectionnée dans le groupe composé d'une couche PSG, d'une couche de nitrure et d'une combinaison de celles-ci.

3. Procédé de test de tranche selon la revendication 1, **caractérisé en ce que** l'étape (a) est exécutée par une gravure suffisamment excessive d'une couche d'isolation intermédiaire intercalée entre ladite couche de passivation et lesdits éléments de programme pour rendre son épaisseur inférieure à 800 nm (8000 Å), afin de minimiser la défaillance de coupure des éléments de programme par le faisceau laser.

4. Procédé de test de tranche selon la revendication 1, **caractérisé en ce que** l'étape (a) est exécutée en ouvrant une portion de repère d'alignement pour la réparation au laser tout en effectuant simultanément l'ouverture des pastilles.
